(19) **Europäisches Patentamt**

**European Patent Office**

**Office européen des brevets**

(11) **EP 1 394 101 A2**

(12) **EUROPÄISCHE PATENTANMELDUNG**

(43) Veröffentlichungstag:
**03.03.2004 Patentblatt 2004/10**

(51) Int Cl.⁷: $B81C\ 1/00$

(21) Anmeldenummer: **03019360.1**

(22) Anmeldetag: **27.08.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **27.08.2002 DE 10239307**

(71) Anmelder:
• **HAHN-SCHICKARD-GESELLSCHAFT FÜR ANGEWANDTE FORSCHUNG E.V.**
**D-78052 Villingen-Schwenningen (DE)**
• **HYGRAMA AG**
**6300 Zug (CH)**

(72) Erfinder:
• **Schaible, Jochen, Dr.**
**72213 Altensteig (DE)**
• **Nommensen, Peter**
**78054 Villingen-Schwenningen (DE)**

(74) Vertreter: **Schoppe, Fritz, Dipl.-Ing.**
**Patentanwälte Schoppe, Zimmermann, Stöckeler & Zinkler,**
**P.O. Box 246**
**82043 Pullach bei München (DE)**

(54) **Verfahren zum selektiven Waferbonden**

(57) Zum mechanischen Verbinden einer Verbindungsoberfläche eines ersten Substrats (10) mit einer Verbindungsoberfläche eines zweiten Substrats (12) wird das erste Substrat bearbeitet, um an einem ersten Abschnitt (20a) der Verbindungsoberfläche des ersten Substrats eine Oberflächenrauhheit zu erhalten, die kleiner als eine vorbestimmte Oberflächenrauhheit ist, und um an einem zweiten Abschnitt (20b) der Verbindungsoberfläche des ersten Substrats eine Oberflächenrauhheit zu erhalten, die größer als die vorbestimmte Oberflächenrauhheit ist. Anschließend wird das erste Substrat durch Waferbonden mit dem zweiten Substrat verbunden, wobei sich die Verbindungsoberfläche des ersten Substrats und die Verbindungsoberfläche des zweiten Substrats berühren.

FIG. 1

EP 1 394 101 A2

**Beschreibung**

Die vorliegende Erfindung bezieht sich auf ein Verfahren zum selektiven Verbinden zweier Substrate mittels Waferbonden sowie auf ein Bauelement, das durch selektives Waferbonden zweier Substrate hergestellt ist, und ein Substrat zum Herstellen eines solchen Bauelements.

Die klassischen Strukturierungsverfahren der Halbleitertechnologie beruhen auf verschiedenen Lithographie- und Ätz-Schritten sowie Dick- und Dünnschichttechniken. Diese besitzen eine hohe Reproduzierbarkeit und sind untereinander kombinierbar. Sie ermöglichen eine von einer Oberfläche ausgehende ein- oder zweidimensionale Bearbeitung bzw. Strukturierung. Eine Herstellung dreidimensionaler Tiefenprofile mit Hinterschneidungen ist jedoch nur eingeschränkt möglich. Die Erzeugung freistehender Elemente, welche sich in der Tiefe definiert bewegen lassen, ist in der Regel nur durch Einsatz von Opferschichten möglich.

Deutlich mehr Gestaltungsfreiheit resultiert beim Aufbau komplexer Strukturen, insbesondere dreidimensionaler Strukturen, aus zwei oder mehreren einzelnen Wafern bzw. Substraten. Diese Substrate werden zunächst separat strukturiert. Anschließend werden die Substrate flächig aufeinander montiert bzw. miteinander mechanisch verbunden und erreichen erst bei diesem Schritt ihre volle Strukturfunktionalität. Dabei resultieren jedoch sehr hohe Anforderungen an die Justage- und Verbindungstechniken.

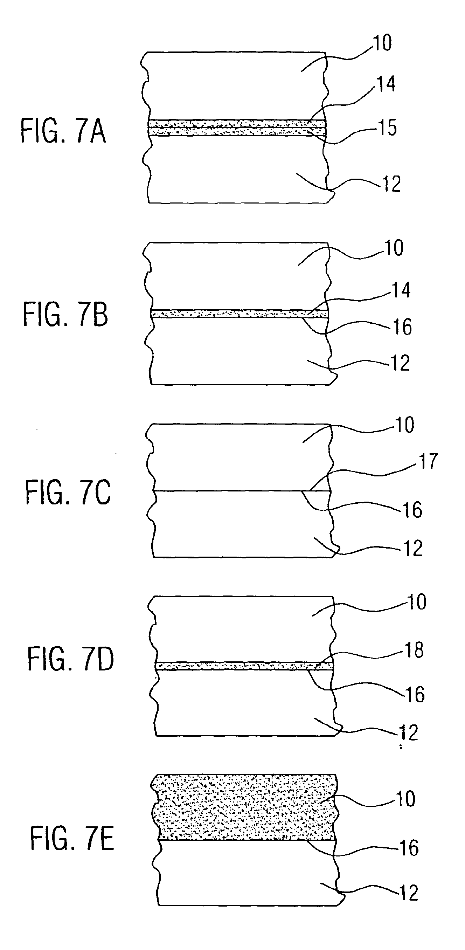

Weit verbreitete und wirtschaftlich vorteilhafte Verfahren zur mechanisch stabilen Verbindung von Substraten und zur Bildung von Multiwaferstrukturen sind als Direkt-Wafer-Bond-Verfahren (DWB-Verfahren) bekannt. Die stabile stoffschlüssige Verbindung zweier Substrate beruht dabei auf einem thermischen bzw. elektrothermischen Füge- und Verbindungsvorgang. Die Fig. 7A bis 7E zeigen schematische Schnittdarstellungen von jeweils zwei Substraten, die durch verschiedene DWB-Verfahren verbunden sind. Die dargestellten Schnittebenen liegen dabei jeweils senkrecht zu den beiden Substraten bzw. der Grenz- und Verbindungs-Fläche zwischen denselben.

Beim SOI-Bonden (SOI = Semiconductor On Insulator = Halbleiter auf Isolator) bzw. Halbleiter-auf-Isolator-Bonden, dessen Produkte in den Fig. 7A und 7B dargestellt sind, weisen beide (Fig. 7A) oder eines (Fig. 7B) der Substrate 10, 12 oxidierte Oberflächen bzw. Oxidschichten 14, 15 auf. Das SOI-Bonden umfaßt eine Ausbildung einer stabilen mechanischen Verbindung durch eine chemische oder elektrochemische, gegebenenfalls thermisch unterstützte Reaktion zwischen der Oxidschicht 14 des einen Substrats 10 und der Oxidschicht 15 bzw. der oxidfreien Oberfläche 16 des anderen Substrats 12.

Beim Siliziumdirektbondverfahren (SDB-Verfahren) bzw. Siliziumdirektbonden, dessen Produkt in Fig. 7C dargestellt ist, werden blanke bzw. oxidfreie Oberflächen 16, 17 der Substrate 10, 12 direkt miteinander verbunden.

Beim anodischen Bonden (AB), dessen Produkte in den Fig. 7D und 7E dargestellt sind, wird eine Pyrex-Schicht 18 auf ein Substrat 10 aufgebracht bzw. auf diesem erzeugt. Anschließend wird die Pyrex-Schicht durch anodisches Bonden mit einer blanken bzw. oxidfreien Oberfläche 16 eines weiteren Substrats 12 verbunden (Fig. 7D). Alternativ wird ein Pyrex-Substrat 10 mit einer blanken bzw. oxidfreien Oberfläche 16 eines Halbleitersubstrats 12 verbunden (Fig. 7E).

Allen bekannten DWB-Verfahren ist gemein, daß sämtliche in mechanischem Kontakt befindliche Abschnitte der Oberflächen der Substrate 10, 12 miteinander mehr oder weniger feste chemische Verbindungen eingehen und dadurch mechanisch verbunden werden. Das Hauptaugenmerk liegt dabei auf einer wirtschaftlich vorteilhaften Erzeugung einer homogenen, dauerhaften und stoffschlüssigen Verbindung.

Bei zahlreichen Anwendungen, beispielsweise mechanischen Schaltelementen, sind jedoch räumlich selektive mechanische Verbindungen zwischen Substraten erwünscht, d. h. einzelne Abschnitte zweier Oberflächen zweier Substrate sollen miteinander verbunden werden während andere Abschnitte nicht miteinander verbunden werden sollen, obwohl sie einander berühren.

Um selektive bzw. räumlich selektive mechanische Verbindungen zwischen Substraten zu bilden, werden bondverhindernde Schichten oder Oberflächen verwendet. Diese bondverhindernden Schichten werden auf Abschnitte aufgebracht bzw. auf Abschnitten erzeugt, die keine mechanische Verbindung mit einer Oberfläche, die sie berühren, eingehen bzw. bilden sollen. Für bondverhindernde Schichten wird neben verschiedenen Metallen vor allem Siliziumnitrid verwendet, das insbesondere für Hochtemperatur-Bondverfahren geeignet ist. Metall- oder Siliziumnitrid-Schichten können mit Standardverfahren der Mikrosystemtechnik erzeugt werden.

Nachteilhaft an einer Verwendung von lateral strukturierten bondverhindernden Schichten aus Metall oder Siliziumnitrid ist vor allem, daß ihre Erzeugung zusätzliche Technologieschritte erforderlich macht. Ferner erhöhen diese bondverhindernden Schichten den Materialmix der hergestellten Struktur. Damit geht zwangsläufig eine Veränderung von deren mechanischen, chemischen und thermischen Eigenschaften einher. Dies hat insbesondere Auswirkungen auf dünne Membranen und andere mechanisch empfindliche Bauteile.

Eine Alternative besteht darin, zwei Substrate mittels selektiver bzw. räumlich selektiver Klebeverfahren zu verbinden. Damit sind mechanische entkoppelte Mehrlagenaufbauten realisierbar. Diese sind jedoch nur begrenzt batchfähig bzw. stapelfähig, durch einen hohen Fertigungs- und Justageaufwand gekennzeichnet und unter wirtschaftlichen Gesichtspunkten für Massenprozesse bzw. eine Massenproduktion wenig geeignet.

Die Aufgabe der vorliegenden Erfindung besteht darin, ein vereinfachtes Verfahren zum mechanischen Verbinden zweier Substrate sowie ein Bauelement, das zwei miteinander verbundene Substrate aufweist, und ein Substrat für ein erfindungsgemäßes Bauelement zu schaffen.

Diese Aufgabe wird durch ein Verfahren gemäß Anspruch 1, ein Bauelement gemäß Anspruch 14 und ein Substrat gemäß Anspruch 22 gelöst.

Der vorliegenden Erfindung liegt die Idee zugrunde, die Rauhheit einer Oberfläche eines ersten Substrats räumlich bzw. lateral auf eine vorbestimmte Weise zu modulieren, um beim Verbinden, insbesondere Waferbonden, der Oberfläche des ersten Substrats mit einer Oberfläche eines zweiten Substrats eine entsprechende räumlich bzw. lateral selektive Waferbond-Verbindung zu erhalten. Wenn zwei einander gegenüberliegende und beim Waferbonden einander berührende Abschnitte der Oberflächen der beiden Substrate jeweils eine geringe Oberflächenrauhheit aufweisen, so wird zwischen diesen Abschnitten eine Bondverbindung gebildet. Wenn hingegen auch nur einer der beiden einander gegenüberliegenden Abschnitte der Oberflächen der beiden Substrate eine große Oberflächenrauhheit aufweist, wird beim Waferbonden keine Bond-Verbindung gebildet. Der Schwellenwert der Oberflächenrauhheit, unterhalb dessen eine Bond-Verbindung zustande kommt, und oberhalb dessen keine Bond-Verbindung zustande kommt, ist von den beiden Substraten, insbesondere den Materialien an ihren Oberflächen und von dem verwendeten Wafer-Bondverfahren abhängig. Jedes Wafer-Bondverfahren wird durch eine Reihe von Parametern beschrieben, beispielsweise durch die Temperatur, den Druck, gegebenenfalls die Stromdichte, die Zeitdauer der Einwirkung dieser Parameter etc.

Ferner liegt der vorliegenden Erfindung die Erkenntnis zugrunde, daß eine Oberflächenrauhheit einer Oberfläche eines Substrats auf eine prozeßtechnisch einfache und leicht steuerbare Weise durch Ätzen vergrößert und durch chemisch-mechanisches Polieren verringert werden kann.

Die vorliegende Erfindung beschreibt ein Verfahren zum selektiven Verbinden von zwei oder mehr Wafern bzw. Substraten, die vorzugsweise zumindest teilweise strukturiert sind und ferner vorzugsweise eine bewegbare bzw. elastische Struktur aufweisen. Durch Oberflächenbehandlungsverfahren, die Ätz- und Politurprozesse umfassen, werden Teilbereiche von Berührungsflächen der Substrate gezielt für den Verbindungsvorgang aktiviert oder deaktiviert. Dadurch kann zwischen den Berührflächen der Verbindungspartner gezielt bzw. vorbestimmt eine selektive Verbindung erzeugt werden.

Die Verbindungspartner bzw. Substrate werden so aufeinandergefügt, daß sich ihre Oberflächen zumindest teilweise berühren. Bei einer thermomechanischen oder elektrothermomechanischen Behandlung wird in den aktivierten Kontaktbereichen eine stabile mechanische Verbindung erzeugt. Die nicht aktivierten bzw. deaktivierten Kontaktbereiche gehen jedoch selbst dann keine mechanische Bindung ein, wenn sie während des Verbindungsprozesses durch eine äußere zusätzliche Kraft aneinandergepreßt werden.

Ein Vorteil der Erfindung besteht darin, daß Abschnitte von Oberflächen zweier Substrate, die durch Waferbonden oder ein anderes Verbindungsverfahren miteinander verbunden werden, ungebondet bleiben können und dann frei aufeinander gleiten oder voneinander abgehoben werden können. Die Elastizität bzw. Beweglichkeit elastischer Strukturbereiche wird erhalten, und gleichzeitig können senkrecht zu den einander berührenden aber nicht miteinander verbundenen Flächen Kräfte übertragen werden.

Ein weiterer Vorteil der vorliegenden Erfindung besteht darin, daß sie ein lateral selektives Verbinden zweier Substrate durch Waferbonden ermöglicht ohne dazu zusätzliche Materialschichten zu erfordern. Dabei können oxidierte oder oxidfreie Oberflächen von Silizium- oder anderen Halbleitersubstraten, Pyrex-beschichtete Substrate oder Pyrex-Substrate gebondet werden.

Eine Anwendung der vorliegenden Erfindung sind (mikromechanische) Schaltelemente, Mikroventile, Mikroantriebe und Sensoren etc., deren Ruhestellung und Schaltkräfte über die mechanische Vorspannung der beweglichen Strukturen definiert und prozeßabhängig eingestellt werden können. Dabei kann mindestens eines der miteinander zu verbindenden Substrate ein- oder beidseitig strukturiert und in beliebiger Richtung mit Durchgangsöffnungen oder Gräben versehen sein. Bewegliche mechanische Strukturen sind beispielsweise Biegebalken oder Membranelemente mit oder ohne Mittenversteifung. Zur Erzeugung einer mechanischen Vorspannung wird vorzugsweise ein Stufenprofil in den starren und/oder in den beweglichen Verbindungspartner integriert.

Bevorzugte Weiterbildungen der vorliegenden Erfindung sind in den Unteransprüchen definiert.

Nachfolgend werden bevorzugte Ausführungsbeispiele der vorliegenden Erfindung anhand der beiliegenden Figuren näher erläutert. Es zeigen:

Fig. 1      eine schematische Schnittdarstellung eines ersten Ausführungsbeispieles der vorliegenden Erfindung;

Fig. 2      eine schematische Schnittdarstellung eines weiteren Ausführungsbeispieles der vorliegenden Erfindung;

Fig. 3A und 3B      schematische Schnittdarstellungen zweier Prinzipien zur Erzeugung einer Vorspannung;

Fig. 4      eine schematische Schnittdarstellung eines weiteren Ausführungsbeispieles der vorliegenden Erfindung;

Fig. 5 eine schematische Darstellung eines Herstellungsverfahrens gemäß der vorliegenden Erfindung;

Fig. 6 eine schematische Schnittdarstellung zu einem Herstellungsverfahren gemäß der vorliegenden Erfindung;

Fig. 7A bis 7E schematische Schnittdarstellungen, die verschiedene Waferbond-Verbindungen zeigen.

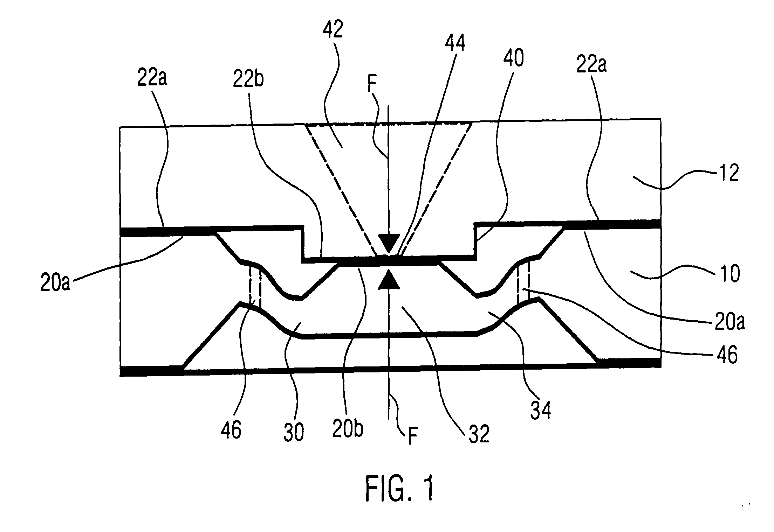

Fig. 1 ist eine schematische Schnittdarstellung eines Bauelements gemäß einem ersten Ausführungsbeispiel der vorliegenden Erfindung. Das Bauelement ist aus einem ersten Substrat 10 und einem zweiten Substrat 12 aufgebaut. Das erste Substrat 10 weist eine Verbindungsoberfläche 20a, 20b auf, und das zweite Substrat 12 weist eine Verbindungsoberfläche 22a, 22b auf. Der dargestellte Schnitt durch das Bauelement ist ein vertikaler Schnitt bzw. ein Schnitt senkrecht zu den Verbindungsoberflächen 20a, 20b, 22a, 22b. Die Substrate 10, 12 und das aus ihnen gebildete Bauelement sind vorzugsweise im wesentlichen axialsymmetrisch zu einer Achse, die zu den Verbindungsoberflächen 20a, 20b, 22a, 22b senkrecht ist. Diese Achse liegt ferner vorzugsweise in der dargestellten Schnittebene.

Ein erster Abschnitt 20a der Verbindungsoberfläche des ersten Substrats 10 grenzt an einen ersten Abschnitt 22a der Verbindungsoberfläche des zweiten Substrats 12 und ist mit diesem durch Waferbonden mechanisch fest verbunden. Ein zweiter Abschnitt 20b der Verbindungsoberfläche des ersten Substrats 10 berührt einen zweiten Abschnitt 22b der Verbindungsoberfläche des zweiten Substrats 12, ist mit diesem jedoch nicht mechanisch verbunden.

Das erste Substrat 10 weist eine vorzugsweise quadratische, rechteckige oder kreisförmige Membran 30 mit einem zentralen Versteifungsbereich 32 und einem elastischen Bereich 34, der den Versteifungsbereich 32 ringförmig umgibt, auf. Die Membran 30 bzw. deren Versteifungsbereich 32 und elastischer Bereich 34 sind vorzugsweise durch ein lateral strukturiertes Ätzen des ersten Substrats 10 von beiden Seiten gebildet. Der Versteifungsbereich 32 weist eine Dicke auf, aufgrund derer er in sich steif und durch eine äußere Kraft im wesentlichen unverformbar ist. Der elastische Bereich 34 weist eine so geringe Dicke auf, daß er durch eine äußere Krafteinwirkung elastisch verformbar ist. Der erste Abschnitt 20a der Verbindungsoberfläche des ersten Substrats 10 ist außerhalb der Membran 30 angeordnet und umschließt dieselbe in lateraler Richtung vorzugsweise vollständig. Der zweite Abschnitt 20b der Verbindungsoberfläche des ersten Substrats 10 ist an dem Versteifungsbereich 32 angeordnet.

Zwischen dem ersten Abschnitt 22a und dem zweiten Abschnitt 22b weist die Verbindungsoberfläche des zweiten Substrats 12 eine Stufe 40 auf, so daß der zweite Abschnitt 22b gegenüber einer durch den ersten Abschnitt 22a definierten Ebene in Richtung zu dem ersten Substrat 10 vorsteht.

Der zweite Abschnitt 20b und der erste Abschnitt 20a der Verbindungsoberfläche des ersten Substrats 10 liegen bei der Herstellung des ersten Substrats 10 in einer Ebene. Beim Zusammenfügen der Substrate 10, 12 bewirkt der überstehende zweite Abschnitt 22b der Verbindungsoberfläche des zweiten Substrats 12, daß der zweite Abschnitt 20b der Verbindungsoberfläche des ersten Substrats 10 bzw. der Versteifungsbereich 32 der Membran 30 aus ihrer Ruhelage ausgelenkt und der elastische Bereich 34 elastisch verformt werden. Dadurch werden die zweiten Abschnitte 20b, 22b der Verbindungsoberflächen der Substrate 10, 12 gegeneinander vorgespannt. Das heißt sie werden durch die elastischen Kräfte des elastischen Bereiches 34 mit einer Kraft F aufeinander gedrückt. Der Betrag der Kraft F ist von den Abmessungen und der Dicke des elastischen Bereiches 34 der Membran 30, von ihrem Material bzw. dessen Elastizitätsmodul und der Höhe der Stufe 40 abhängig.

Das in Fig. 1 dargestellte Bauelement weist im zweiten Substrat 12 eine Durchgangsöffnung bzw. eine Fluidleitung 42 auf. Eine Öffnung 44 der Fluidleitung 42 ist inmitten des zweiten Abschnittes 22b der Verbindungsoberfläche des zweiten Substrats 12 angeordnet und wird durch den anliegenden Versteifungsbereich 32 bzw. den anliegenden zweiten Abschnitt 20b der Verbindungsoberfläche des ersten Substrats 10 fluiddicht verschlossen. Im elastischen Bereich 34 der Membran 30 kann eine Mehrzahl von Durchgangsöffnungen bzw. Fluidleitungen 46 angeordnet sein.

Das dargestellte Bauelement ist ein Mikroventil. Im Normalzustand wird die Öffnung 44 durch den am zweiten Abschnitt 22b der Verbindungsoberfläche des zweiten Substrats 12 anliegenden zweiten Abschnitt 20b der Verbindungsoberfläche des ersten Substrats 10 fluiddicht verschlossen. Dadurch besteht keine Fluidkommunikation zwischen der Fluidleitung 42 im zweiten Substrat 12 und den Fluidleitungen 46 im ersten Substrat 10. Durch eine äußere Kraft, beispielsweise durch Fluiddruck, durch eine elektrostatische, piezoelektrische oder eine magnetische Kraft, kann die Membran 30 bzw. das Versteifungsgebiet 32 gegen die Kraft F noch stärker ausgelegt werden. Dadurch wird der zweite Abschnitt 20b der Verbindungsoberfläche des ersten Substrats 10 von dem zweiten Abschnitt 22b der Verbindungsoberfläche des zweiten Substrats 12 und von der Öffnung 44 der Fluidleitung 42 abgehoben. Es entsteht eine Fluidkommunikation zwischen der Fluidleitung 42 im zweiten Substrat 12 und den Fluidleitungen 46 im ersten Substrat 10.

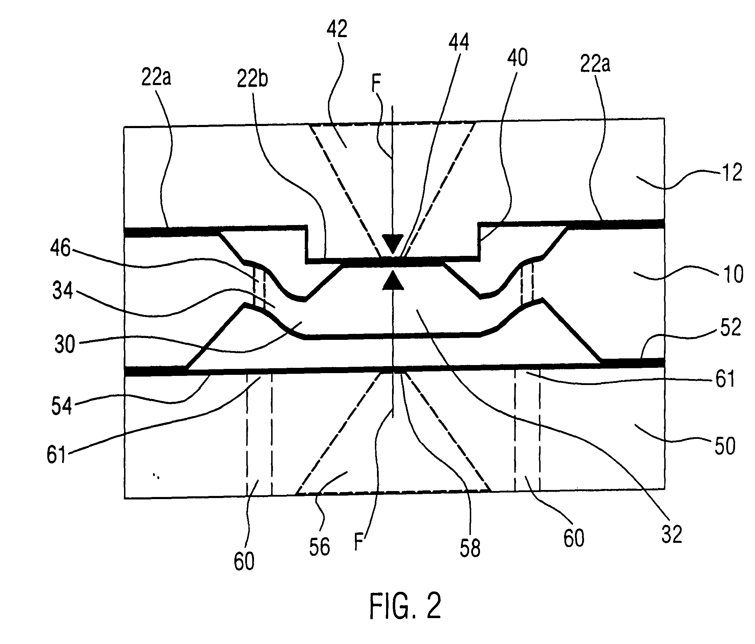

Fig. 2 ist eine schematische Schnittdarstellung eines weiteren Ausführungsbeispieles eines Bauelements gemäß der vorliegenden Erfindung. Dargestellt ist wiederum ein vertikaler Schnitt durch das Bauelement. Dieses Ausführungsbeispiel unterscheidet sich von dem in Fig. 1 dargestellten Ausführungsbeispiel durch ein drittes Substrat 50. Das erste Substrat 10 weist eine weitere Verbindungsoberfläche 52 auf, die planparallel zum ersten Abschnitt 22a der Verbindungsoberfläche und dieser im wesentlichen gegenüberliegend an der anderen Seite des ersten Substrats 10 angeordnet ist. Das dritte Substrat 50 weist eine Verbindungsoberfläche 54 auf, welche die weitere Verbindungsoberfläche 52 des ersten Substrats 10 berührt und mit dieser durch Waferbonden verbunden ist. Insgesamt entsteht so eine SandwichAnordnung, bei der das erste Substrat 10 stapelförmig zwischen dem zweiten Substrat 12 und dem dritten Substrat 50 angeordnet ist.

Das dritte Substrat 50 weist eine Fluidleitung 56 auf, die gegenüber der Fluidleitung 42 des zweiten Substrats 12 und bezüglich des ersten Substrats 10 im wesentlichen spiegelsymmetrisch zu derselben angeordnet ist. Die Fluidleitung 56 weist eine Öffnung 58 an der Verbindungsoberfläche 52 des dritten Substrats 50 auf. Diese Öffnung 58 liegt dem Versteifungsbereich 32 der Membran 30 gegenüber. Solange die Membran 30 nicht maximal ausgelenkt ist wird sie von dem Versteifungsbereich 32 nicht verschlossen, da die Dicke des Versteifungsbereiches geringer ist als der Abstand zwischen dem zweiten Abschnitt 22b der Verbindungsoberfläche des zweiten Substrats 12 und der Verbindungsoberfläche 54 des dritten Substrats 50. Ferner weist das dritte Substrat 5 50 vorzugsweise eine oder mehrere Fluidleitungen 60 auf, deren Öffnungen 61 im Bereich der bzw. gegenüber dem elastischen Bereich 34 angeordnet sind. Die Öffnungen 61 der Fluidleitungen 60 werden deshalb durch den Versteifungsbereich 32 der Membran 30 auch bei deren maximaler Auslenkung nicht verschlossen.

Ohne Einwirkung einer äußeren Kraft besteht keine Fluidkommunikation zwischen der Fluidleitung 42 im zweiten Substrat 12 und den Fluidleitungen 56 und 60 im dritten Substrat 50, da die Membran 30 bzw. deren Versteifungsbereich 32 wie im vorangehenden Ausführungsbeispiel beschrieben gegen den zweiten Abschnitt 22b der Verbindungsoberfläche des zweiten Substrats 12 vorgespannt ist und so die Öffnung 44 der Fluidleitung 42 verschließt. In diesem Zustand besteht jedoch eine Fluidkommunikation zwischen der Fluidleitung 56 und den Fluidleitungen 60.

Wenn der Versteifungsbereich 32 der Membran 30 durch eine äußere Kraft, beispielsweise einen Fluiddruck in der Fluidleitung 42 im zweiten Substrat 12, durch eine elektrostatische, magnetische oder piezoelektrische Kraft, von der Öffnung 44 der Fluidleitung 42 im zweiten Substrat 12 abgehoben wird, entsteht eine Fluidkommunikation zwischen der Fluidleitung 42 im zweiten Substrat 12 und den Fluidleitungen 56 und 60 im dritten Substrat 50 durch die Fluidleitungen 46 in der Membran 30 hindurch.

Bei maximaler Auslenkung des Versteifungsbereiches 32 liegt dieser an der Verbindungsoberfläche 54 des dritten Substrats 50 an und verschließt somit die Öffnung 58 der Fluidleitung 56. Damit besteht nur noch eine Fluidkommunikation zwischen der Fluidleitung 42 im zweiten Substrat und den Fluidleitungen 60 im dritten Substrat.

Das anhand der Fig. 2 dargestellte Mikroventil wird vorzugsweise so betrieben, daß der Versteifungsbereich 32 nur in den zwei Anschlagpositionen vorliegt bzw. nur zwischen denselben hin- und herschaltet, und dabei immer nur sehr kurzzeitig in Zwischenstellungen vorliegt. Das Mikroventil ist damit ein klassisches 3/2-Wege-Umschaltventil, mit dem zwischen zwei alternativen Fluidwegen (Fluidleitung 42 - Fluidleitungen 60 oder Fluidleitung 56 - Fluidleitung 60) umgeschaltet werden kann.

Vorzugsweise wird der Versteifungsbereich 32 der Membran 30 elektrostatisch bewegt. Dazu weisen das erste Substrat 10 einschließlich der Membran 30 und dem Versteifungsbereich 32 der Membran 30 sowie das dritte Substrat 50 ein elektrisch leitfähiges Material, beispielsweise ein Halbleitermaterial auf. Das erste Substrat 10 und das dritte Substrat 50 sind durch eine isolierende Schicht zwischen bzw. an ihren Verbindungsoberflächen 52, 54 elektrisch voneinander isoliert. Diese isolierende Schicht ist beispielsweise eine Oxidschicht, die durch Oxidation der weiteren Verbindungsoberfläche 52 des ersten Substrats 10 und/oder der Verbindungsoberfläche 54 des dritten Substrats 50 erzeugt wird. Nach Erzeugung der Oxidschicht werden die weitere Verbindungsoberfläche 52 des ersten Substrats 10 und die Verbindungsoberfläche 54 des dritten Substrats 50 durch SOI-Bonden miteinander verbunden.

Wenn eine Spannung zwischen dem ersten Substrat 10 und dem dritten Substrat 50 angelegt wird, erfahren die Membran 30 und insbesondere ihr Versteifungsbereich 32 eine anziehende Kraft, die zu dem dritten Substrat 50 bzw. seiner Verbindungsoberfläche 54 hin gerichtet ist. Wenn die angelegte Spannung ausreichend hoch ist, ist die erzeugte elektrostatische Anziehung zwischen dem Versteifungsbereich 32 der Membran 30 einerseits und dem dritten Substrat 50 andererseits größer als die Kraft F, mit der der Versteifungsbereich 32 gegen den zweiten Abschnitt 22b der Verbindungsoberfläche des zweiten Substrats 12 mechanisch vorgespannt ist. Dadurch wird der Versteifungsbereich 32 von der Öffnung 44 der Fluidleitung 42 abgehoben bzw. das Mikroventil geöffnet. Durch Variation der angelegten Spannung können der Grad der Öffnung und damit der Strömungswiderstand zwischen der Fluidleitung 42 im zweiten Substrat 12 und der Fluidleitung 56 im dritten Substrat 50 variiert werden.

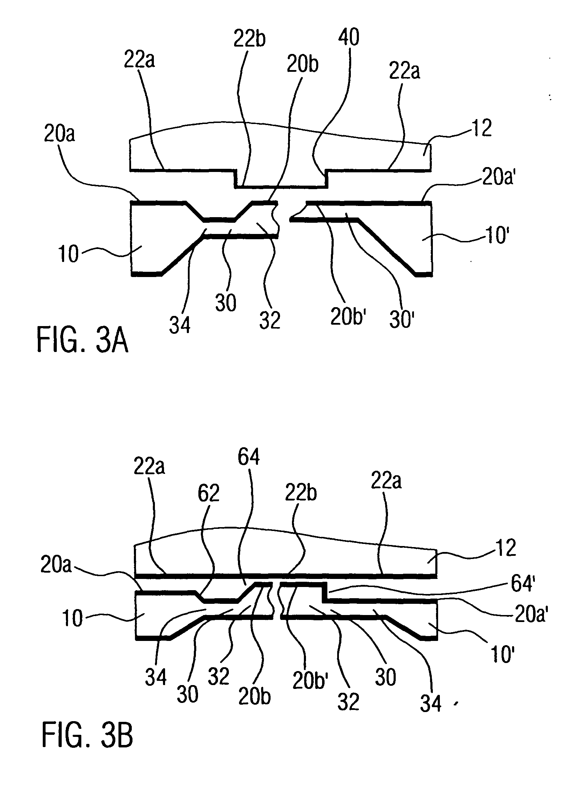

Fig. 3A und 3B zeigen in schematischen Schnittdarstellungen zwei Möglichkeiten zur Erzeugung einer mechanischen Vorspannung eines elastischen Baugliedes bzw. einer Membran 30. Die Membran 30 ist wie in den anhand der Fig. 1 und 2 dargestellten Ausführungsbeispielen Bestandteil eines ersten Substrats 10. Ein zweites Substrat 12 ist dem ersten Substrat 10 bzw. seiner Verbindungsoberfläche 20a, 20b gegenüber angeordnet jedoch beabstandet dargestellt. Die Fig. 3A und 3B können als Momentaufnahmen im Herstellungsprozeß unmittelbar vor dem Zusammenfügen der beiden Substrate angesehen werden. Die Membran 30 bzw. deren elastischer Bereich 34 ist dabei noch unverformt.

In Fig. 3A sind ein erster Abschnitt 20a und ein zweiter Abschnitt 20b der Verbindungsoberfläche des ersten Substrats 10 koplanar angeordnet bzw. liegen in derselben Ebene. Zwischen dem ersten Abschnitt 22a und dem zweiten Abschnitt 22b der Verbindungsoberfläche des zweiten Substrats 12 ist eine Stufe 40 angeordnet, so daß der zweite Abschnitt 22b gegenüber dem ersten Abschnitt 22a in Richtung zu dem ersten Substrat 10 vorsteht. Dadurch wird beim Verbinden der ersten Abschnitte 20a, 22a der Verbindungsoberflächen der Substrate 10, 12 die Membran 30 bzw. deren Versteifungsbereich 32 gegen den zweiten Abschnitt 22b der Verbindungsoberfläche des zweiten Substrats 12 mechanisch vorgespannt. Diese Geometrie entspricht der aus den anhand der Fig. 1 und 2 dargestellten Ausführungsbeispielen. bei denen die mechanische Vorspannung ebenfalls durch eine Stufe 40 in der Verbindungsoberfläche des zweiten Substrats 12 erzeugt wird.

In Fig. 3A sind zwei Varianten des ersten Substrats 10 dargestellt. Bei dem in der linken Bildhälfte dargestellten Substrat 10 ist der elastische Bereich 34 der Membran 30 durch Dünnen des Substrats 10 von beiden Oberflächen her erzeugt. Die Abschnitte 20a, 20b der Verbindungsoberfläche des ersten Substrats 10 sind deshalb räumlich voneinander beabstandet.

Bei dem in der rechten Bildhälfte dargestellten Substrat 10' ist die Membran 30' durch Dünnen des Substrats 10' nur von der Rückseite bzw. der der Verbindungsoberfläche 20a', 20b' gegenüberliegenden Oberfläche her erzeugt. Der erste Abschnitt 20a' und der zweite Abschnitt 20b' der Verbindungsoberfläche des Substrats 10' gehen also ineinander über. Alternativ wird der erste Abschnitt 20a' der Verbindungsoberfläche des Substrats 10' beispielsweise als der Abschnitt definiert, der beim anschließenden Verbinden der Substrate 10', 12 den ersten Abschnitt 22a der Verbindungsoberfläche des zweiten Substrats 12 berührt und mit diesem mechanisch verbunden wird. Dabei wird der zweite Abschnitt 20b' an der Verbindungsoberfläche des ersten Substrats 10 als derjenige Abschnitt definiert, der beim Verbinden der Substrate 10', 12 den zweiten Abschnitt 22b der Verbindungsoberfläche des zweiten Substrats 12 berührt. Wenn die Abschnitte 20a', 20b' so definiert sind, sind sie voneinander beabstandet.

Fig. 3B zeigt den zu Fig. 3A komplementären Fall. Die Verbindungsoberfläche 22a, 22b des zweiten Substrats 12 ist planar und weist keine Stufe 40 auf. Der erste Abschnitt 20a und der zweite Abschnitt 20b der Verbindungsoberfläche des ersten Substrats 10 sind parallel zueinander, jedoch nicht koplanar angeordnet. Statt dessen steht der zweite Abschnitt 20b gegenüber dem ersten Abschnitt 20a in Richtung auf das zweite Substrat 12 vor. Beim Zusammenfügen der Substrate 10, 12 bzw. der ersten Abschnitte 20a, 22a der Verbindungsoberflächen der Substrate 10, 12 wird der Versteifungsbereich 32 der Membran 30 gegen die Verbindungsoberfläche 22a, 22b des zweiten Substrats 12 mechanisch vorgespannt.

In Fig. 3B sind wiederum zwei Varianten dargestellt. In der linken Bildhälfte ist zwischen dem elastischen Bereich 34 und dem ersten Abschnitt 20a der Verbindungsoberfläche des ersten Substrats 10 eine erste Stufe 62 angeordnet, und zwischen dem elastischen Bereich 34 und dem zweiten Abschnitt 20b der Verbindungsoberfläche des ersten Substrats 10 bzw. dem Versteifungsbereich 32 ist eine zweite Stufe 64 angeordnet. Der Überstand des zweiten Abschnittes 20b der Verbindungsoberfläche des ersten Substrats 10 gegenüber dem ersten Abschnitt 20a ergibt sich aus einem Unterschied zwischen den Höhen der Stufen 62, 64.

In Fig. 3B rechts dargestellt ist eine Variante, die keine Stufe zwischen dem elastischen Bereich 34' und dem ersten Abschnitt 20a' der Verbindungsoberfläche des ersten Substrats 10' aufweist. Eine Stufe 64' zwischen dem elastischen Bereich 34' und dem Versteifungsbereich 32' der Membran 30' bestimmt alleine den Höhenversatz des zweiten Abschnittes 20b' der Verbindungsoberfläche des ersten Substrats 10' gegenüber dem ersten Abschnitt 20a'.

Alternativ springen die zweiten Abschnitte 22b, 20b der Verbindungsoberflächen beider Substrate 10, 12 gegenüber den jeweils ersten Abschnitten derselben Verbindungsoberfläche vor, um eine mechanische Vorspannung der Membran zu erzeugen.

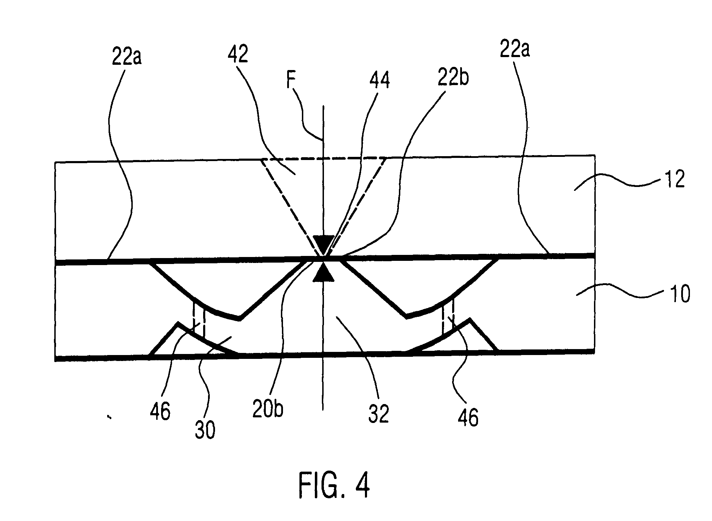

Fig. 4 ist eine schematische Schnittdarstellung eines weiteren Ausführungsbeispieles der vorliegenden Erfindung. Dieses Ausführungsbeispiel unterscheidet sich von dem anhand der Fig. 1 dargestellten Ausführungsbeispiel dadurch, daß die Verbindungsoberfläche 22a, 22b des zweiten Substrats 12 keine Stufe aufweist. Der erste Abschnitt 22a und der zweite Abschnitt 22b der Verbindungsoberfläche des zweiten Substrats 12 sind vielmehr koplanar bzw. in einer Ebene angeordnet. Eine Vorspannung des Verstärkungsbereiches 32 der Membran 30 des ersten Substrats 10 bzw. des zweiten Abschnitts 20b der Verbindungsoberfläche des ersten Substrats 10 gegen den zweiten Abschnitt 22b der Verbindungsoberfläche des zweiten Substrats 12 wird auf die anhand der Fig. 3B oben beschriebene Weise erzielt. Der zweite Abschnitt 20b der Verbindungsoberfläche des ersten Substrats 10 steht im entspannten Zustand, d. h. insbesondere vor dem Zusammensetzen und Verbinden der Substrate 10, 12, gegenüber dem ersten Abschnitt 20a der Verbindungsoberfläche des ersten Substrats 10 über.

In diesem Ausführungsbeispiel ist die Dicke des Versteifungsbereiches 32 der Membran 30 genauso groß wie die Dicke des Substrats 10 außerhalb der Membran 30.

Bei den anhand der Fig. 1, 2 und 4 dargestellten Ausführungsbeispielen eines Bauelements gemäß der vorliegenden Erfindung weisen die Membran 30 sowie ihr Versteifungsbereich 32 und ihr elastischer Bereich 34 vorzugsweise eine Achsensymmetrie bzw. eine Rotationssymmetrie zu einer Achse senkrecht zu der ersten Verbindungsoberfläche 10 auf. Alternativ weist die Membran 30 die Form eines Ellipsoids, eines Rechtecks, eines allgemeinen Vielecks oder eine beliebige andere Form auf.

Der Versteifungsbereich 32 der Membran 30 gewährleistet, daß der zweite Abschnitt 20b der Verbindungsoberfläche des Substrats 10 auch bei einer Auslenkung der Membran 30 plan ist und somit flächig an dem zweiten Abschnitt 22b der Verbindungsoberfläche des zweiten Substrats 12 anliegt und die Öffnung 44 der Fluidleitung 43 fluiddicht verschließt. Alternativ weist die Membran 30 keinen Versteifungsbereich 32 auf. Die Auslenkung der Membran 30 aus ihrer Ruhelage, die sie einnimmt, wenn keine Kräfte auf sie wirken, hat dann in der Regel auch eine Verformung des zweiten Abschnittes 20b der Verbindungsoberfläche des ersten Substrats 10 zur Folge. Bei einer geeigneten Ausgestaltung des zweiten Abschnittes 22b der Verbindungsoberfläche des zweiten Substrats 12 und insbesondere der lateralen Form der Stufe 40 verschließt der zweite Abschnitt 20b der Verbindungsoberfläche des ersten Substrats 10 die Öffnung 44 der Fluidleitung 42 dennoch fluiddicht. Eine geeignete Ausgestaltung ist beispielsweise insbesondere eine Rotationssymmetrie des zweiten Abschnittes 22b der Verbindungsoberfläche des zweiten Substrats 12 und der Stufe 40 relativ zu derselben Achse, bezüglich derer die Membran 30 rotationssymmetrisch ist.

Die Fluidleitungen 42, 46, 56, 60 sind in den dargestellten Ausführungsbeispielen ebenfalls symmetrisch bezüglich der gleichen Symmetrieachse angeordnet. Alternativ sind eine oder mehrere Fluidleitungen 46 asymmetrisch und/oder außerhalb des elastischen Bereiches 34 der Membran 30 oder im Versteifungsbereich 32 angeordnet. Die Fluidleitung 56 im dritten Substrat 50 kann ebenfalls wie die Fluidleitung 60 auch asymmetrisch angeordnet sein. Vorzugsweise sind die Fluidleitung 56 und ihre Öffnung 58 so angeordnet, daß sie auch bei einer maximalen Auslenkung des Versteifungsbereiches 32, bei der derselben an der Verbindungsoberfläche 54 des dritten Substrats 50 anliegt, nicht verschlossen werden.

Alternativ sind die Fluidleitungen anders angeordnet und weisen einen anderen Verlauf auf als es in den Fig. 1, 2 und 4 dargestellt ist. Vorteilhaft ist insbesondere auch eine Anordnung einer zweiten Fluidleitung im zweiten Substrat 12, so daß beide Fluidanschlüsse des Ventils an derselben Seite des Bauelements angeordnet sind. In diesem Fall sind einerseits keine Fluidleitungen 46 in der Membran 30 erforderlich. Andererseits ist auch kein Fluid in dem Raum zwischen der Membran 30 und dem dritten Substrat 50, in dem bei dem oben beschriebenen elektrostatischen Antrieb des Ventils ein elektrisches Feld vorliegt. In diesem Fall eignet sich das Ventil auch für Fluide, die in elektrischen Feldern Veränderungen erfahren bzw. gegenüber elektrischen Feldern empfindlich sind.

Anstelle der Membran 30 wird alternativ ein anderes elastisches Bauglied verwendet, das eine Öffnung einer Fluidleitung gesteuert verschließen kann, beispielsweise ein elastischer Balken.

In den dargestellten Ausführungsbeispielen ist das bewegliche bzw. elastische Bauglied so vorgespannt, daß es ohne äußere Einwirkung eine Fluidkommunikation unterbricht indem es eine Öffnung verschließt. Alternativ ist das elastische Bauglied nicht vorgespannt oder umgekehrt so vorgespannt, daß ohne äußere Einwirkung eine Fluidkommunikation zwischen zwei Fluidanschlüssen des Ventils besteht. In diesem Fall wird vorzugsweise durch Anlegen eines elektrischen oder magnetischen Feldes, durch Fluiddruck oder durch eine andere äußere Kraft das elastische Bauglied so bewegt, daß die Fluidkommunikation unterbrochen wird, indem eine Öffnung verschlossen wird.

Die vorliegende Erfindung ist darüber hinaus bei vielen anderen mechanischen bzw. mikromechanischen Bauelementen anwendbar, die einen Stapel aus zwei oder mehr Substraten aufweisen, die durch Waferbonden selektiv miteinander verbunden sind. Besonders vorteilhaft ist die vorliegende Erfindung immer dann, wenn nur bestimmte Abschnitte sich berührender Oberflächen durch Waferbonden miteinander verbunden werden sollen, während andere Abschnitte keine mechanische Verbindung eingehen sollen obwohl sie während des Waferbondens einander berühren. In den anhand der Fig. 1, 2 und 4 dargestellten Ausführungsbeispielen müssen die ersten Abschnitte 20a, 22a der Verbindungsoberflächen der Substrate 10, 12 durch Waferbonden miteinander mechanisch verbunden werden. Die zweiten Abschnitte 20b, 22b der Verbindungsoberflächen der Substrate 10, 12 dürfen hingegen nicht mechanisch miteinander verbunden sein, damit sie zum Öffnen des Ventils jeweils ohne weiteres voneinander getrennt werden können.

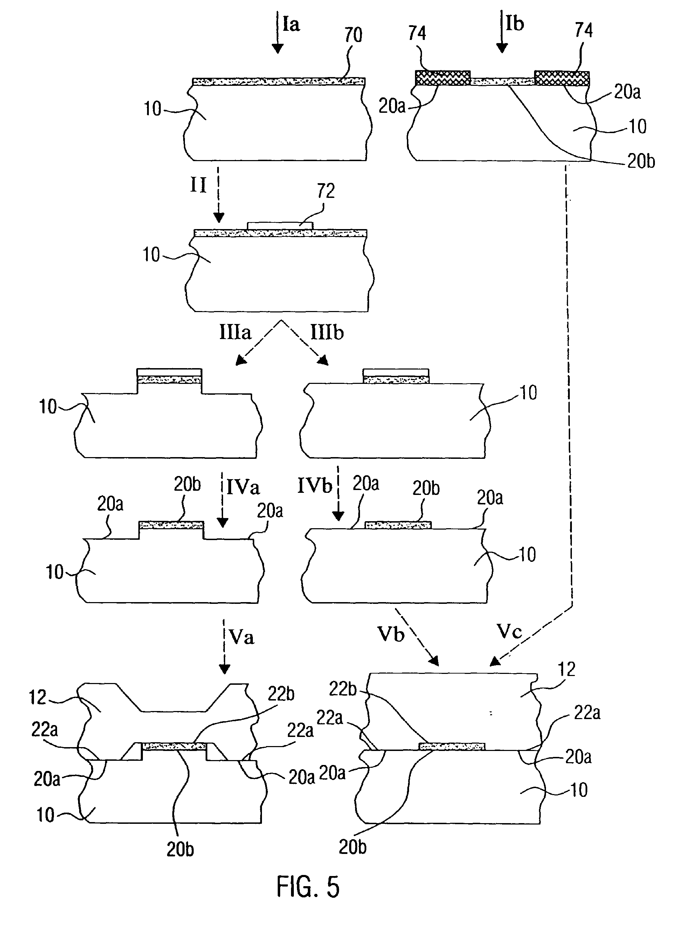

Nachfolgend wird anhand der Fig. 5 beschrieben, wie gemäß der vorliegenden Erfindung eine räumlich bzw. lateral se-5 lektive Bondverbindung zwischen zwei Substraten erzeugbar ist.

Grundvoraussetzung für eine stabile DWB-Verbindung ist eine extrem hohe Oberflächengüte der miteinander zu verbindenden Oberflächen der Substrate. Bereits geringste naß- oder trockenchemische Ätzungen von wenigen Nanometern Tiefe schädigen eine Substratoberfläche so stark, daß eine Verbindung mit einer anderen Oberfläche durch Waferbonden nicht mehr möglich ist. Für eine Waferbond-Verbindung vorgesehene Bereiche einer Substratoberfläche dürfen deshalb nicht mit den bekannten Silizium-Ätzverfahren bearbeitet werden. Um die Bondfähigkeit einer durch Ätzen geschädigten Substratoberfläche wieder herzustellen, muß deren Oberflächengüte mittels eines Politurverfahrens verbessert werden. Das hier beschriebene selektive Bondverfahren macht sich diesen Sachverhalt zu nutze.

In einem ersten Schritt Ia wird die Oberfläche bzw. Verbindungsoberfläche des einen Bondpartners 10 zunächst ganzflächig überätzt. Dies geschieht beispielsweise mit heißer 33-prozentiger wäßriger Kaliumhydroxidlösung (KOH) bei einer Mindestätzzeit von 10 Minuten. Es entsteht eine leicht angerauhte Oberfläche 70 mit einer Oberflächenrauhheit bzw. einer Rauhtiefe $R_z \approx 0,018\,\mu m$. Diese stellt zwar weiterhin eine spiegelnde technische Planfläche dar, ist jedoch bereits unbondbar. In diesem Dokument angegebene Größen für Rauhtiefen beziehen sich auf Messungen mit dem Profilometer TENCOR P11.

Die Rauhtiefe $R_z$ ist ein Maß für die Rauhigkeit einer O-berfläche. Sie wird durch Profilmessungen entlang n Einzelmeßstrecken ermittelt. Für jede Einzelmeßstrecke ist die Einzelrauhtiefe $R_{zi}$, die Summe aus der Höhe der größten Profilspitze und der Tiefe des größten Profiltales innerhalb der Einzelmeßstrecke. Die Rauhtiefe $R_z$ ist der arithmetische Mittelwert der Einzelrauhtiefen

$$R_{zi} \quad R_z = \frac{1}{n}\sum_{i=1}^{n} R_{zi}\,.$$

In einem zweiten Schritt IIa wird eine Maskierschicht bzw. Maske 72 in den Abschnitten auf die angerauhte Oberfläche 70 aufgebracht, die rauh bleiben sollen. Die Maske 72 weist vorzugsweise Gold, Chrom-Gold oder gold auf anderen Haftvermittlern, wie z. B. WoTi, auf. Die Schichtdicke der Maske 72 beträgt abhängig von der Bearbeitungszeit bzw. der Dicke der in einem nachfolgenden Polierschritt abzutragenden Schicht mindestens 200 nm.

In einem dritten Schritt werden die Abschnitte der angerauhten Oberfläche 70, die nicht durch die Maske 72 bedeckt sind, chemisch-mechanisch poliert. Dies geschieht unter Beigabe einer schwach ätzenden Politurlösung (vorzugsweise 3,3% wäßrige KOH), die die mechanische Abtragung der angerauhten Oberfläche 70 chemisch unterstützt. Durch das chemisch-mechanische Politurverfahren (CMP) wird die Oberflächengüte des Substrats 10 an den nicht durch die Maske 72 bedeckten Abschnitten verbessert. Über die Prozeßparameter kann eingestellt werden, ob und wie stark die Oberfläche des Substrats 10 gleichzeitig tiefenstrukturiert wird. Durch intensives chemisch-mechanisches Polieren (IIIa) erfolgt eine Tiefenstrukturierung, deren laterale Gestalt durch die Maske 72 bestimmt ist. Bei einem minimalen Materialabtrag (IIIb) wird lediglich die angerauhte Oberfläche 70 abgetragen, um die Oberflächengüte zu verbessern, und es erfolgt praktisch keine Tiefenstrukturierung. Durch den Po-5 liturschritt wird eine verbesserte Oberflächenqualität mit einer Rauhtief $R_z \leq 0,014\,\mu m$ erzeugt, welche die hohen qualitativen Anforderungen des Waferbondens erfüllt.

In einem vierten Schritt IVa, IVb wird die Maske 72 entfernt. Es resultiert eine mehr oder weniger stark tiefenstrukturierte Oberfläche 20a, 20b mit bondbaren bzw. aktivierten Abschnitten 20a und unbondbaren bzw. inaktivierten Abschnitten 20b.

5 In einem fünften Schritt Va, Vb wird das Substrat 10 durch Waferbonden mit einem weiteren Substrat 12 verbunden. Wenn die Verbindungsoberfläche des Substrats 10 in vorangegangenen Schritten stark tiefenstrukturiert wurde (IVa), muß das weitere Substrat 12 eine entsprechende Tiefenstrukturierung oder eine ausreichende Elastizität aufweisen (Va). Wenn bei dem vorangegangenen Politurverfahren nur eine minimale Tiefenstrukturierung der Oberfläche 20a, 20b erfolgte (IVb) kann das Substrat 10 auch mit einem steifen bzw. unflexiblen weiteren Substrat 12 verbunden werden (Vb) . In beiden Fällen bilden aktivierte bzw. bondbare Abschnitte 20a mit Oberflächenabschnitten 22a des weiteren Substrats 12 stabile, stoffschlüssige Verbindungen aus, während inaktivierte bzw. unbondbare Abschnitte 20b mit Oberflächenabschnitten 22b des weiteren Substrats 12 auch dann keine Bondverbindung ausbilden, wenn sie diese berühren.

Oberflächenabschnitte eines Substrats werden also gemäß der vorliegenden Erfindung für eine Bondverbindung aktiviert, indem durch ein Politurverfahren eine hohe Oberflächengüte bzw. eine geringe Rauhtiefe $R_z$ erzeugt wird. Dies geschieht vorzugsweise durch chemisch-mechanisches Polieren. Abschnitte einer Verbindungsoberfläche eines Substrats werden für eine Bondverbindung inaktiviert, indem ihre Oberflächengüte herabgesetzt bzw. ihre Rauhtiefe $R_z$ vergrößert wird. Dies geschieht vorzugsweise durch einen Ätzschritt.

Alternativ zu den dargestellten Verfahrensschritten wird die Verbindungsoberfläche 20a, 20b eines Substrats 10 vor dem ersten Ätzschritt Ib in denjenigen Abschnitten 20a mit einer Maske 74 bedeckt, die nicht inaktiviert werden sollen. Durch den Ätzschritt Ib werden somit von vornherein nur diejenigen Abschnitte 20b angeätzt bzw. angerauht, welche für den nachfolgenden Bondschritt inaktiviert werden sollen. Nach dem Entfernen der Maske 74 kann das Substrat 10 dann unmittelbar in einem Schritt Vc durch Waferbonden mit dem weiteren Substrat 12 verbunden werden.

Bei dem anhand der Fig. 5 beschriebenen Verfahren wird eines der beiden Substrate selektiv aktiviert bzw. deaktiviert. Sowohl strukturierte als auch unstrukturierte Substrate können mit den Schritten I - IV aktiviert oder deaktiviert werden. Alternativ wird anstelle des Substrats bzw. Bondpartners 10 mit der ebenen Oberfläche das weitere Substrat 12, das in Fig. 5 strukturiert ist und insbesondere eine Membran aufweist, selektiv aktiviert und deaktiviert. Eine weitere Alternative ist die selektive Aktivierung und Deaktivierung beider Substrate durch Polieren bzw. Ätzen.

Oben wurde bereits beschrieben, wie durch Stufen 40, 62, 64 bzw. vorstehende Abschnitte 20b, 22b der Verbindungsoberflächen eine mechanische Vorspannung eines elastischen Baugliedes erzeugt werden kann. Da die Tiefenstrukturierung einer Verbindungsoberfläche bei einem Politurschritt durch die Fertigungsparameter dieses Politurschrittes gesteuert wird (Schritt IIIa), werden auch Ruhelage und Anpreßkraft der elastischen bzw. beweglichen Strukturen durch die Fertigungsparameter eingestellt.

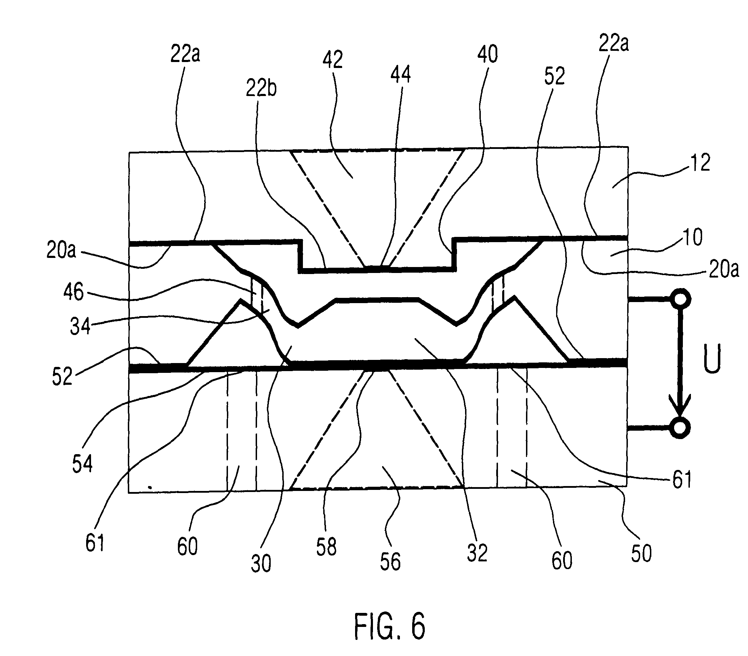

Anhand der Fig. 6 wird im folgenden eine Variante des erfindungsgemäßen Herstellungsverfahrens beschrieben. Fig. 6 ist wiederum eine schematische Schnittdarstellung eines Bauelements, das dem anhand der Fig. 2 dargestellten zweiten Ausführungsbeispiel entspricht.

Wie bereits oben beschrieben eignet sich die vorliegende Erfindung besonders für Bauelemente, die Substratstapel aus zwei (Fig. 1) oder mehr (Fig. 2) Substraten 10, 12, 50 mit elastischen bzw. beweglichen, mechanisch vorgespannten bzw. sich in den elastischen Bereichen berührenden Baugliedern 30 aufweisen. Dabei sollen die Substrate 10, 12 mittels eines SOI-Bondverfahrens oder eines SDB-Verfahrens selektiv stoffschlüssig miteinander verbunden werden. Ein selektives Bonden, bei dem nur bestimmte Abschnitte der Verbindungsoberflächen eine Bondverbindung ausbilden, ist dabei erforderlich, um die Funktion des Bauelements zu gewährleisten.

Beim Zusammenfügen von Substraten 10, 12 mit elastischen Strukturen 30, die dabei mechanisch vorgespannt werden, muß eine von außen auf die Substrate wirkende Fügekraft zunächst die Rückstellkraft des elastischen Elements überwinden, um dasselbe aus seiner Ruhelage auszulenken bis die miteinander durch Bonden zu verbindenden Abschnitte 20a, 22a einander berühren. Der Substratstapel 10, 12 wird dazu vorzugsweise zwischen zwei planparallelen Flächen so weit zusammengepreßt, bis sämtliche zu bondenden Abschnitte 20a, 22a der Verbindungsoberflächen der Substrate 10, 12 aneinander anliegen.

Die aktivierten Berührflächen 20a, 22a sind hydrophil. Zwischen ihnen bilden sich Wasserstoffbrückenbindungen aus, infolge derer die Substrate auch nach Entfernen der externen Anpreßkraft spontan aneinander haften. Diese Haftkraft kann verstärkt werden, indem die Substrate bei anliegender externer Anpreßkraft auf Temperaturen zwischen 400°C und 600°C aufgeheizt werden. Bei diesen Temperaturen verfestigen sich bereits in der hier beschriebenen Vorbondphase die chemischen Bindungen zwischen den Kontaktflächen. Die Stabilität der Verbindung wird dadurch deutlich erhöht, und es können auch Substrate mit elastischen Baugliedern mit hohen mechanischen Rückstellkräften verarbeitet werden.

Die Rückstellkraft eines elastischen Baugliedes, das zum Zwecke der Erzeugung einer mechanischen Vorspannung beim Zusammenfügen der Substrate aus seiner Ruhelage ausgelenkt wird, wird gemäß der vorliegenden Erfindung verringert oder ausgeschaltet, indem auf elektrostatischem Wege eine entgegenwirkende Kraft auf das elastische Bauglied ausgeübt wird. Dazu eignen sich vor allem Siliziumwafer oder andere Halbleitersubstrate 10, 12, die, wie es beim SOI-Bonden üblich ist, durch eine elektrisch isolierende Schicht 14, 15 getrennt sind. In diesem Fall kann durch Anlegen einer elektrischen Spannung zwischen dem ersten Substrat 10 und dem dritten Substrat 50 ein elektrostatisches Feld zwischen dem beweglichen Bauglied 30 und dem dritten Substrat 50 erzeugt werden. Im Fall eines Bauelements, das nur zwei Substrate 10, 12 aufweist, wird die elektrische Spannung zwischen dem ersten Substrat 10 und einer an diesem anliegenden Anpreßplatte angelegt. Die Anpreßplatte ist in diesem Fall eine Anpreßelektrodenplatte. Mittels des elektrischen Feldes wird die elastische Struktur 30 von dem dritten Substrat 50 bzw. der Anpreßelektrodenplatte angezogen und bei einer entsprechend hohen elektrischen Spannung bis zum Anschlag ausgelenkt. Das elastische Bauglied 30 wird also von dem zweiten Substrat 12 bzw. dem zweiten Abschnitt 22b der Verbindungsoberfläche des zweiten Substrats 12 weggezogen. Dadurch wird die Kraft, die das elastische Bauglied auf das zweite Substrat 12 ausübt, reduziert oder vollständig abgebaut.

Die Bondverbindung zwischen dem ersten Abschnitt der Oberfläche des ersten Substrats 10 und dem ersten Abschnitt der Oberfläche des zweiten Substrats 12 wird somit in ihrer Entstehungsphase und insbesondere in der Vorbondphase weniger oder gar nicht durch die elastische Rückstellkraft des elastischen Bauglieds mechanisch belastet. Dadurch kann die Haftung der Substrate 10, 12 so weit stabilisiert werden, daß sich die Substrate auch nach Entfernen der externen Anpreßkraft und der elektrischen Spannung nicht mehr zerstörungsfrei trennen lassen.

Gleichzeitig wird dadurch, daß die Kraft zwischen dem elastischen Bauglied und dem zweiten Substrat vollständig abgebaut oder so stark reduziert wird, bewirkt, daß keine Bondverbindung zwischen dem elastischen Bauglied und dem zweiten Substrat entstehen.

Anschließend wird der Substratstapel ohne weitere Hilfsmaßnahmen, d. h. insbesondere ohne externe Fügekraft und ohne elektrische Spannung zwischen dem ersten Substrat 10 und dem dritten Substrat 50 der Hochtemperaturbehandlung des SOI-Bondverfahrens oder des SDB-Verfahrens unterzogen. Bei Temperaturen zwischen 800°C und 1100°C findet an den Bondflächen die vollständige chemische Umwandlung der Wasserstoffbrückenbindungen in dauerhafte atomare Bindungen statt.

Gemäß dem beschriebenen Ausführungsbeispiel wird das elastische Bauglied 30 zumindest während der Vorbondphase elektrostatisch ausgelenkt oder von dem zweiten Substrat 12 weggezogen. Alternativ wird das elastische Bauglied während des gesamten Bondvorganges ausgelenkt oder von dem zweiten Substrat 12 weggezogen. Anstatt wie beschrieben elektrostatisch wird alternativ auf magnetostatische, piezoelektrische oder eine andere Weise eine Kraft auf das elastische Bauglied ausgeübt.

## Patentansprüche

1. Verfahren zum mechanischen Verbinden einer Verbindungsoberfläche (20a, 20b) eines ersten Substrats (10) mit einer Verbindungsoberfläche (22a, 22b) eines zweiten Substrats (12), mit folgenden Schritten:

   Bearbeiten (Ia, Ib, II, IIIa, IIIb, IVa, IVb) des ersten Substrats (10), um an einem ersten Abschnitt (20a) der Verbindungsoberfläche des ersten Substrats (10) eine Oberflächenrauhheit zu erhalten, die kleiner als eine vorbestimmte Oberflächenrauhheit ist, und um an einem zweiten Abschnitt (20b) der Verbindungsoberfläche des ersten Substrats (10) eine Oberflächenrauhheit zu erhalten, die größer als die vorbestimmte Oberflächenrauhheit ist; und

   Verbinden (Va, Vb, Vc) des ersten Substrats (10) und des zweiten Substrats (12), wobei sich die Verbindungsoberfläche (20a, 20b) des ersten Substrats (10) und die Verbindungsoberfläche (22a, 22b) des zweiten Substrats (12) berühren.

2. Verfahren nach Anspruch 1, bei dem der zweite Abschnitt (20b) vor dem Schritt des Verbindens (Va) gegenüber dem ersten Abschnitt (20a) vorsteht, und bei dem der Schritt des Verbindens (Va) einen Schritt des elastischen Verformens des ersten Substrats (10) umfaßt, bei dem der zweite Abschnitt (20b) verschoben wird und gegen die Verbindungsoberfläche (22a, 22b) des zweiten Substrats (12) vorgespannt wird.

3. Verfahren nach Anspruch 1 oder 2, bei dem ein dem zweiten Abschnitt (20b) der Verbindungsoberfläche des ersten Substrats (10) gegenüberliegender Abschnitt (22b) der Verbindungsoberfläche des zweiten Substrats (12) gegenüber einem dem ersten Abschnitt (20a) der Verbindungsoberfläche des ersten Substrats (10) gegenüberliegenden Abschnitt (22a) der Verbindungsoberfläche des zweiten Substrats (12) vorsteht, und bei dem der Schritt des Verbindens (Va) einen Schritt des elastischen Verformens des ersten Substrats (10) umfaßt, bei dem der zweite Abschnitt (20b) verschoben und gegen die Verbindungsoberfläche (22a, 22b) des zweiten Substrats (12) vorgespannt wird.

4. Verfahren nach einem der Ansprüche 1 bis 3, bei dem der Schritt des Bearbeitens einen Schritt des chemisch-mechanischen Polierens (IIIa, IIIb) des ersten Abschnitts (20a) umfaßt.

5. Verfahren nach einem der Ansprüche 1 bis 4, bei dem der Schritt des Bearbeitens einen Schritt des Anätzens (Ia, Ib) des zweiten Abschnittes (20b) umfaßt.

6. Verfahren nach einem der Ansprüche 1 bis 5, bei dem die vorbestimmte Oberflächenrauhheit einer Rauhtiefe $R_z$ = 0,015 µm entspricht.

7. Verfahren nach Anspruch 6, bei dem der Schritt des Bearbeitens einen Schritt des Bearbeitens (Ia, Ib, IIIa, IIIb) des ersten Substrats (10) umfaßt, um an dem ersten Abschnitt (20a) eine Rauhtiefe zu erhalten, die $R_z$ = 0,014 µm oder weniger beträgt, und um an dem zweiten Abschnitt (20) eine Rauhtiefe zu erhalten, die $R_z$ = 0,018 µm oder mehr beträgt.

8. Verfahren nach einem der Ansprüche 1 bis 7, bei dem der Schritt des Verbindens einen Schritt des Waferbondens umfaßt.

9. Verfahren nach einem der Ansprüche 1 bis 8, bei dem der Schritt des Verbindens einen Schritt des Erwärmens des ersten Substrats und des zweiten Substrats und/oder einen Schritt des Zusammmendrückens des ersten Substrats und des zweiten Substrats und/oder einen Schritt des Erzeugens eines elektrischen Potentialgefälles zwischen dem ersten und dem zweiten Substrat aufweist.

10. Verfahren nach einem der Ansprüche 1 bis 9, bei dem das erste Substrat (10) ein Halbleitermaterial aufweist und das zweite Substrat (12) ein Halbleitermaterial aufweist und das erste Substrat (10) und/oder das zweite Substrat (12) an der Verbindungsoberfläche (20a, 20b, 22a, 22b) eine Oxidschicht aufweisen, und bei dem der Schritt des Waferbondens (Va, Vb, Vc) einen Schritt des Halbleiter-auf-Isolator-Bondens umfaßt.

11. Verfahren nach einem der Ansprüche 1 bis 9, bei dem das erste Substrat (10) ein Halbleitermaterial aufweist und das zweite Substrat ein Halbleitermaterial aufweist und die Verbindungsoberflächen der Substrate (10, 12) Halbleiteroberflächen sind, und bei dem der Schritt des Waferbondens einen Schritt des Halbleiterdirektbondens umfaßt.

12. Verfahren nach einem der Ansprüche 1 bis 9, bei dem eines der beiden Substrate (10, 12) ein Halbleitermaterial aufweist und das andere Substrat (10, 12) ein Glas oder eine Glasschicht an der Verbindungsoberfläche (20a, 20b, 22a, 22b) aufweist, und bei dem der Schritt des Waferbondens (Va, Vb, Vc) einen Schritt des anodischen Bondens umfaßt.

13. Verfahren nach einem der Ansprüche 1 bis 12, ferner mit einem Schritt des Ausübens einer Kraft auf einen Abschnitt des ersten Substrats in einer Richtung von dem zweiten Substrat weg.

14. Bauelement mit folgenden Merkmalen:

einem ersten Substrat (10) mit einer Verbindungsoberfläche (20a, 20b); und

einem zweiten Substrat (12) mit einer Verbindungsoberfläche (22a, 22b),

wobei ein erster Abschnitt (20a) der Verbindungsoberfläche des ersten Substrats (10) mit der Verbindungsoberfläche (22a, 22b) des zweiten Substrats (12) durch ein Waferbond-Verfahren verbunden ist, und wobei ein zweiter Abschnitt (20b) der Verbindungsoberfläche des ersten Substrats (10) die Verbindungsoberfläche des zweiten Substrats (12) berührt und eine Oberflächenrauheit aufweist, bei der ein Verbinden durch das Waferbond-Verfahren nicht möglich ist.

15. Bauelement nach Anspruch 14, bei dem der zweite Abschnitt (20b) der Verbindungsoberfläche des ersten Substrats (10) elastisch auslenkbar ist und gegen die Verbindungsoberfläche (22a, 22b) des zweiten Substrats (12) mechanisch vorgespannt ist.

16. Bauelement nach Anspruch 14 oder 15, bei dem der zweite Abschnitt (20b) der Verbindungsoberfläche des ersten Substrats (10) elektrostatisch, magnetisch, piezoelektrisch, durch einen Fluiddruck oder durch eine andere äußere Kraft von der Oberfläche (22a, 22b) des zweiten Substrats (12) abhebbar ist.

17. Bauelement nach einem der Ansprüche 14 bis 16, bei dem der erste Abschnitt (20a) der Verbindungsoberfläche des ersten Substrats (10) an einem Außenrand einer elastischen Membran (30) und der zweite Abschnitt (20b) an einem Versteifungsgebiet der Membran (30) angeordnet sind.

18. Bauelement nach einem der Ansprüche 14 bis 17, ferner mit einem dritten Substrat (50), das an einer von der Verbindungsoberfläche (20a, 20b) des ersten Substrats (10) abgewandten Oberfläche (52) des ersten Substrats (10) angeordnet ist.

19. Bauelement nach einem der Ansprüche 14 bis 18, das ein Ventil umfaßt.

20. Bauelement nach einem der Ansprüche 14 bis 19, bei dem das zweite Substrat (12) eine Fluidleitung (42) mit einer Öffnung (44) an der Verbindungsoberfläche (22a, 22b) des zweiten Substrats (12) aufweist, wobei die Öffnung (44) gegenüber dem zweiten Abschnitt (20b) der Verbindungsoberfläche des ersten Substrats (10) angeordnet ist, wobei das erste Substrat (10) im Bereich des zweiten Abschnitts (20b) seiner Verbindungsoberfläche elastisch verformbar ist, und die Öffnung (44) der Fluidleitung (42) an der Verbindungsoberfläche (22a, 22b) des zweiten Substrats (12) durch den zweiten Abschnitt (20b) der Verbindungsoberfläche des ersten Substrats (10) verschließbar ist.

21. Bauelement nach einem der Ansprüche 14 bis 20, das ein 3/2-Wege-Ventil umfaßt.

22. Substrat (10) mit einer Verbindungsoberfläche (20a, 20b), mit:

einem ersten Abschnitt (20a) an der Verbindungsoberfläche, der ausgebildet ist, um durch ein Waferbond-Verfahren mit einer Verbindungsoberfläche (22a, 22b) eines weiteren Substrats (12) verbunden zu werden; und

einem zweiten Abschnitt (20b) an der Verbindungsoberfläche, der ausgebildet ist, um die Verbindungsoberfläche (22a, 22b) des weiteren Substrats (12) zu berühren und eine Oberflächenrauheit aufweist, bei der ein Verbindung durch das Waferbond-Verfahren nicht möglich ist.

FIG. 1

EP 1 394 101 A2

FIG. 2

EP 1 394 101 A2

EP 1 394 101 A2

FIG. 3A

FIG. 3B

14

FIG. 4

FIG. 5

FIG. 6

EP 1 394 101 A2

FIG. 7A

FIG. 7B

FIG. 7C

FIG. 7D

FIG. 7E